# EUROPEAN PATENT SPECIFICATION

(11) **EP 3 033 757 B1**
(45) Date of publication and mention of the grant of the patent: **03.01.2018**
(21) Application number: 14752325.2
(22) Date of filing: 15.08.2014
(51) Int. Cl.: H01G 9/20, H01L 51/44

(54) **LIGHT HARVESTING PHOTOVOLTAIC DEVICE**
PHOTOVOLTAISCHE LICHTSAMMLUNGSVORRICHTUNG
DISPOSITIF PHOTOVOLTAÏQUE DE COLLECTE DE LUMIÈRE

(30) Priority: 15.08.2013 EP 13180514
(43) Date of publication of application: 22.06.2016
(73) Proprietor: CSEM Centre Suisse d'Electronique et de Microtechnique SA, 2002 Neuchâtel (CH); EMPA Eidgenössische Materialprüfungs- und Forschungsanstalt, CH-8600 Dübendorf (CH)
(72) Inventor: FERRINI, Rolando, CH-3006 Bern (CH); OFFERMANS, Ton, CH-4052 Basel (CH); GALLINET, Benjamin, CH-4132 Muttenz (CH); HANY, Roland, CH-8050 Zürich (CH); NÜESCH, Frank, CH-8602 Wangen (CH); GEIGER, Thomas P., CH-8600 Dübendorf (CH)
(74) Representative: Gevers SA
(86) International application number: PCT/EP2014/067497
(87) International publication number: WO 2015/022424

(56) References cited:
- EP-A1- 1 767 964
- US-A1- 2012 174 980
- US-A1- 2012 255 614
- ROBERT KOEPPE ET AL: "Organic Solar Cells with Semitransparent Metal Back Contacts for Power Window Applications", CHEMSUSCHEM, vol. 2, no. 4, 20 April 2009 (2009-04-20), pages 309-313, XP055088149, ISSN: 1864-5631, DOI: 10.1002/cssc.200900029
- LIOZ ETGAR ET AL: "Mesoscopic CH 3 NH 3 PbI 3 /TiO 2 Heterojunction Solar Cells", JOURNAL OF THE AMERICAN CHEMICAL SOCIETY, vol. 134, no. 42, 24 October 2012 (2012-10-24), pages 17396-17399, XP055083693, ISSN: 0002-7863, DOI: 10.1021/ja307789s
- SEONG SIK SHIN ET AL: "Improved Quantum Efficiency of Highly Efficient Perovskite BaSnO 3 -Based Dye-Sensitized Solar Cells", ACS NANO, vol. 7, no. 2, 26 February 2013 (2013-02-26), pages 1027-1035, XP055083181, ISSN: 1936-0851, DOI: 10.1021/nn305341x

## Description

### Technical Field

The invention relates to the field of photovoltaic devices, more particularly to at least partially transparent photovoltaic devices that incorporate organic or inorganic light harvesting photovoltaic substances.

### Background of the invention

The direct conversion of sunlight into electricity using energy harvesting devices is key for the provision of renewable energy in the future. Efficient use of existing large surface areas in residential buildings can be made by recently developed transparent photovoltaic technology, which can be integrated into, for instance, window panes. Transparent and flexible energy harvesting tools can also be integrated into for example foldable elements such as curtains, or can be integrated into e.g. screens of portable computers and mobile phones, for providing electrical energy to charge the device. In addition, such transparent devices are interesting for powering invisible electronic circuits that are integrated in, for example, automotive windshields.

The use of inorganic semiconductors, such as silicon, for such energy harvesting applications is limited because of these materials' wide absorption spectra in the visible wavelengths. In contrast, certain photosensitive organic molecules show discrete absorptions spectra in specific narrow spectral regions. Research work has so far shown that it is possible to realize semi-transparent organic solar cells having a residual colored aspect that might find applications, for example, in architectural and design motifs. Organic energy harvesting devices which appear fully transparent to the naked eye require specific organic molecules of which the visible light transmittance is maximized while only the ultraviolet and near-infrared radiation is absorbed by these molecules. Not many organic dyes are available that have these peculiar characteristics and that are highly transparent in the visible part of the spectrum and that are suitable for the mentioned applications, as the organic molecules have to be stable under high temperature conditions as well as under ultraviolet and heat radiation.

Some important steps towards fully transparent solar cells having a high optical-electrical conversation factor were recently reported by several organisations. Early efforts to construct semitransparent devices focused on the use of very thin organic layers having absorption in the visible part of the spectrum and therefore have been limited to either low light energy conversion or too low transmission in the visible part of the spectrum. In recent development work, focus has been on near-infrared absorbing devices with relatively high visible light transmission. Mainly two complementary approaches have been investigated in order to find a compromise between maximizing energy conversion and visible light transparency. The first approach consists of using specific selective near-infrared absorbing donors.

The second approach focuses on the transparent electrodes covered with different types of more or less complex coatings especially designed for improving the near-infra-red (NIR) absorption profile in the solar cell.

In particular US2010/0186623 describes photovoltaic cells incorporating small molecules, such as chloro-aluminium-phthalocyanine as electron donor and C60 as electron acceptor, with which an optical-electrical conversion efficiency of 1.7% is claimed, with a total integrated visible transparency of more than 55%.

In another example, J.Meiss et al. disclose in Applied Physics Letters 99, p.193307, 2011,solar cells comprising combination of substances such as Ph2-benz-bodipy and C60 that can allegedly reach an energy conversion efficiency of 2.4% and an average transmittance between 400-750nm of 48%.

There are mainly three problems with the devices disclosed in US 2010/0186623 and J.Meiss et al. The first is that they need complex and expensive vacuum deposition techniques to realize the required layers of the organic photovoltaic cells. The second is that the substrates on which the layers are deposited are solid and expensive materials such as glass sheets (in J.Meiss et al.) or quartz (e.g.in US2010/0186623). Finally, the reported organic photovoltaic devices use dye molecules that have a residual absorption in a portion of the visible spectrum, typically the red part, so that the photovoltaic devices have a residual colored aspect, for example a green-tinted aspect. This is undesirable for instance if the photovoltaic device is integrated into a window pane. The residual colored aspect cannot be modified or corrected easily. Some solutions have been proposed to reduce partially the residual color of the energy harvesting windows. One solution is to incorporate other type of dyes in order to absorb complementary parts of the spectrum, for example green in case of residual red absorption. Other techniques have been proposed such as the deposition of specific designed interference layers. These additional color correction solutions complicate the technology of the organic photovoltaic devices and make it more expensive.

A further alternative to provide solar transparent cells for power window applications is explained in the article of R. Koeppe et al.: "Organic Solar Cells with Semitransparent Metal Back contacts for Power Window Applications", Chemsuchem, vol.2, nr.4, 20 april 2009, pp.309-313. It discloses an organic solar cell comprising a selective anti-reflection layer on the back side of the organic solar cell which is transparent to visible light but reflective to NIR light. This allows the cell to appear transparent and additionally increases the efficiency of the organic solar cell by the increased path length of the incoming light by the reflection of the NIR light on the selective anti-reflection layer. The increased path length and so the electrical conversion efficiency is limited by the single reflection on the selective anti-reflection layer and it would be desirable to further increase the path length and so the electrical conversion efficiency while maintaining a high transparency. Also, the organic solar cell disclosed by R.Koeppe et al. has limited color management possibilities of the transmitted visible light.

Document US 2012/0174980 A1 discloses a solar cell of the dye sensitized and organic type in which a glass window is arranged to the cell comprising a diffraction grating. The diffraction grating allows to selective couple only first order diffractive components into the absorption layer in such a way as to cause multiple excursions of the in-coupled light through the absorption layer.

The solar cell disclosed in US 2012/0174980 has limited visible light throughput and has also a very limited choice of the color of the transmitted light.

### Summary of the invention

The object of this invention is to overcome at least partially the limitations of the photovoltaic devices described in the prior art, and thereby to provide a photoelectric conversion device having a greater photoconversion. Furthermore, the color appearance of said photoelectric conversion device to an observer situated to one side of the photoelectric conversion devices can be specified by light management techniques using particular arrangements of gratings arranged in said photoelectric conversion devices.

The object of the invention is more precisely achieved by a photoelectric conversion device as defined in claim 1, which comprises:
- at least one photoconversion element that comprises at least one organic or inorganic photoconversion layer;
- at least a first grating structure that is arranged on a first side of the photoconversion element;
- at least a second grating structure arranged on a second side of the photoconversion element.

The first grating structure is arranged so as to direct a near-infra-red light portion of light incident on said first grating structure into said photoconversion element, and the at least second grating structure is arranged to reflect at least a part of near-infra-red light back into said photoconversion element, enhancing as such the optical path length and improving the photoconversion efficiency. The first grating structure and the second grating structure are optimized to maximize visible light transmission of the photoelectric conversion device.

According to the invention, the grating structures arranged in the photoconversion elements may be reflective grating structures.

The photoconversion element of the photoelectric conversion device may be a single continuous layer and the at least one of said first grating structure and said second grating structure is arranged also as a single continuous layer. Such an arrangement allows maximizing the photoelectric conversion efficiency.

The at least one photoconversion element may comprise a plurality of separate photoconversion elements, all arranged substantially in the same plane, and the at least one of said first grating structures and said second grating structures comprise a plurality of independent grating structures. In that case, the plurality of independent grating structures each face one of the plurality of photoconversion elements. The embodiment comprising a plurality of separate photoconversion elements allows to maximize the visible light transmission through the photoelectric conversion device.

According to the invention further grating structures may be provided in between each of a plurality of independent grating structures, said further grating structures are arranged to direct, by diffraction, near-infrared-light into the said plurality of photoconversion elements. The further grating structures may be arranged also to reflect and/or transmit a portion of the incident visible light. An embodiment comprising further grating structures allows to improve at the same time the near-infra-red photoconversion efficiency and the visible throughput of the photoelectric conversion device.

According to the invention a waveguiding film may be arranged to at least one side of the photoconversion element. This waveguiding film may be arranged to guide visible or near-infrared light. A waveguiding film is a substantially flat film, comprising a first surface and a second surface, which guides incoupled light into said film by multiple reflections on said first surface and said second surface. The waveguiding film is made of a material having a higher index of refraction than the index of refraction of the surrounding medium of the waveguiding film. A waveguiding film is also known in the literature as a light guide, a waveguiding foil, a light waveguiding film or foil, a film optical waveguide, a light waveguide. In combination with the first grating structure arranged to the waveguiding film, at least a portion of the incident visible light on said first grating structure may be directed away from the photoconversion elements and near-infra-red light incident of said first grating structure is directed towards and into the photoconversion element. The cooperation between a first grating structure and a waveguide such as a waveguiding film arranged to the photoconversion element allows a great design flexibility of the visible and near-infra-red light management in the photoelectric conversion device.

The photoelectric conversion device may be further arranged on a transparent substrate layer, which may have waveguiding properties. The transparent substrate may be used to deposit the different layers comprised in the photoconversion elements. The transparent substrate may further have a second grating structure arranged on said transparent substrate. The use of flexible substrates allows for roll-to roll processing techniques, thus for cost effective, mass production.

According to an embodiment of the invention, said first grating structure and said second grating structure may be arranged to reflect a portion of the visible light incident on said first grating structure and/or second grating structure, said portion corresponding to the visible light with a wavelength range complementary to the absorbed wavelength range of the visible spectrum by said photoconversion element. This allows to impose a specific color appearance of the photoelectric conversion device to an observer. The color appearance may be a neutral color, preferably grey, or a well defined color.

According to another embodiment of the invention said first grating structure may be a reflective grating structure arranged to reflect visible light incident on said reflective grating structure, and according to that embodiment said waveguiding film is arranged to guide said reflected visible light, and further gratings may be arranged and optimized to direct near infrared light onto the photoconversion elements, the further gratings being arranged and optimized also to transmit visible light.

Combining a reflecting first grating structure and the waveguide properties of the waveguiding film allows a wide design flexibility of the photoelectric conversion device and in particular a high visible transmission and high photoconversion efficiency of the photoelectric conversion device.

In an embodiment said photoconversion device comprises at least one inorganic layer comprising one of the following: quantum dots, perovskites, preferably semiconducting perovskites, more preferably a trihalide perovskite (CH3NH3Pbl3),or CH3NH3Pbl(3-x)Clx, or CH3NH3SnI3, or a combination of them.

The object of the invention is also achieved by a method of generating electrical current according to claim 9. The method comprises the following steps:
- receiving incident light comprising at least near-infra-red and visible light at a photoelectric conversion device;
- directing a near-infra-red light portion of said incident light into a photoconversion element of said photoelectric conversion device, said photoconversion element comprising at least one organic photoconversion layer, said photoconversion element thereby producing an electrical current;
- redirecting at least a part of said near-infra-red light portion back into said photoconversion element;
- passing visible light out of the photoelectric conversion device,
wherein at least a portion of the visible part of the light incident on the photoelectric conversion device is reflected and wherein another portion of said visible light is transmitted through the photoelectric conversion device, the reflected portion of the visible part of the light being reflected by means of at least one of a first grating structure arranged on a first side of the photoconversion element and a second grating structure arranged on a second side of the photoconversion element, said reflected portion corresponding to the visible light with a wavelength range complementary to the absorbed wavelength range of the visible spectrum by said photoconversion element.

### Brief description of the drawings

The above described objects and advantages of the present invention will become more readily apparent to those ordinarily skilled in the art after reviewing the following detailed descriptions and accompanying drawings, in which:
- Fig. 1 illustrates an absorption spectrum of a cyanine dye;
- Fig. 2a illustrates a photoelectric conversion device comprising an organic photoconversion layer;
- Fig. 2b illustrates another photoelectric conversion device comprising an organic photoconversion layer;
- Fig. 3a illustrates a waveguiding film;
- Fig. 3b illustrates a transmission curve of a waveguiding film;
- Fig. 4a illustrates a diffraction structure for color correction in transmission;
- Fig. 4b illustrates a corrected transmission spectrum and a reflection spectrum of a diffraction structure designed and arranged for color correction in transmission;
- Fig. 4c illustrates a first grating structure comprising two superposed grating structures
- Fig. 5a illustrates a diffraction structure to diffract a visible light beam incident on a first grating structure;
- Fig. 5b illustrates a transmission spectrum of a diffraction structure to diffract a visible light beam incident on a first grating structure;
- Fig. 6a illustrates a diffraction structure to diffract a near-infra-red light beam incident on a first grating structure;
- Fig. 6b illustrates a transmission spectrum of a diffraction structure to diffract a near-infra-red light beam incident on a first grating structure;
- Fig. 7a illustrates a second grating structure for redirecting near-infra-red light back into the photoconversion element;
- Fig. 7b illustrates the reflection characteristics, in function of wavelength, of the second grating structure of Fig. 7a for redirecting, near-infra-red light back into the photoconversion element;
- Fig.8a illustrates another second grating structure;
- Fig. 8b illustrates the reflection characteristics, in function of wavelength, of the reflecting diffraction structure of Fig. 8a for redirecting near-infra-red light back into the photoconversion element;
- Fig. 9 illustrates a photoelectric conversion device comprising a first grating structure arranged to correct color and a second grating structure for the internal reflection of near-infra-red light into the photoconversion element;
- Fig. 10 illustrates a transmission spectrum of the photoelectric conversion device of Fig.9;
- Fig. 11 a illustrates a reflection spectrum of the photoelectric conversion device of Fig.9;
- Fig. 11b shows the near-infra-red reflection curve of a second grating structure;
- Fig. 12 illustrates a photoelectric conversion device comprising a color correction first grating structure to reflect red light and a second grating structure for the internal reflection of near-infra-red light into the photoconversion element;
- Fig. 13 illustrates a reflection spectrum of the photoelectric conversion device of Fig.12;
- Fig. 14 illustrates a transmission spectrum of the photoelectric conversion device of Fig.12;
- Fig. 15 illustrates a photoelectric conversion device comprising a plurality of photoconversion elements;
- Fig. 16 illustrates a photoelectric conversion device comprising a plurality of photoconversion elements and comprising reflecting structures;
- Fig. 17 illustrates a photoelectric conversion device comprising a plurality of photoconversion elements, and comprising further grating structures arranged between the first grating structures;
- Fig.18 illustrates a photoelectric conversion device comprising a plurality of photoconversion elements, and comprising further grating structures arranged between first grating structures and comprising reflecting structures;
- Fig. 19 illustrates a photoelectric conversion device with the light source positioned to the side of the second grating structure.

### Detailed description

The following detailed description illustrates the principles and examples of embodiments according to the invention. It will thus be appreciated that those skilled in the art will be able to devise various arrangements that, although not explicitly described or shown herein, embody the outlined principles of the invention and are included in its scope as defined in the claims. In the description, similar reference signs refer to the same or similar components or structural elements. Also, the term "transparent" as used herein the description encompasses an average visible transparency of a straight through beam of at least 50%, integrated over the whole visible spectrum (V), which is defined as a wavelength range between 400nm-650nm.

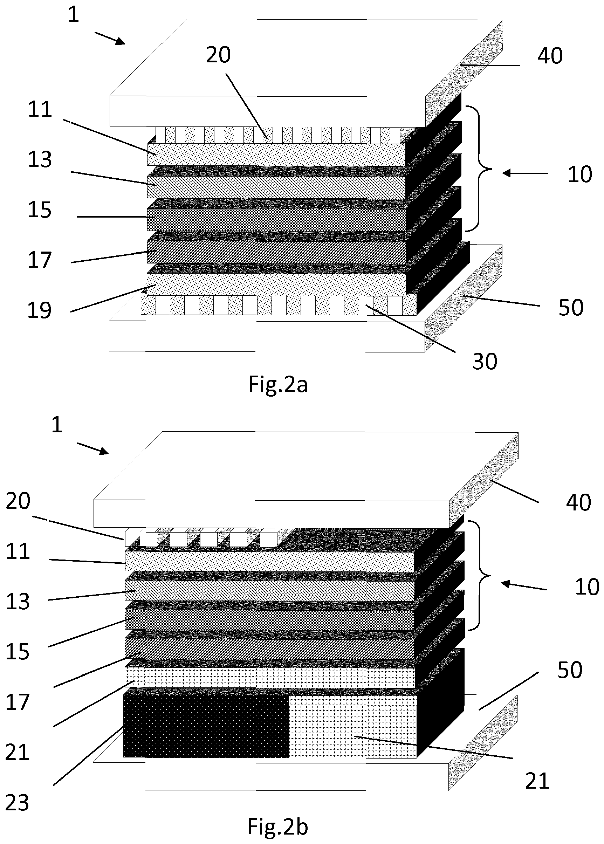

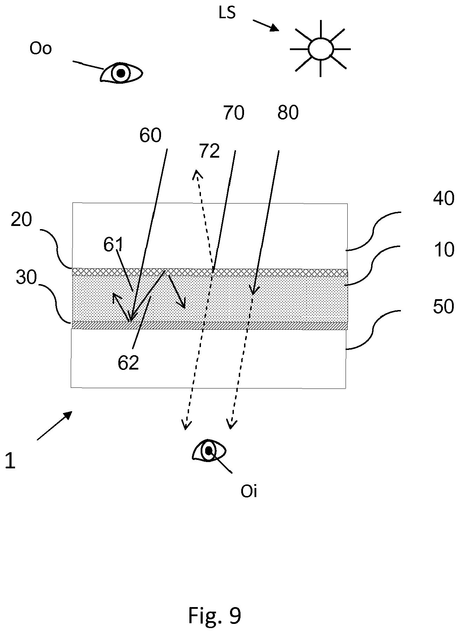

According to a generic embodiment of the invention, illustrated in Fig. 2a and Fig. 9, the photoelectric conversion device 1 comprises a photoconversion element 10, arranged between a first grating structure 20 and a second grating structure 30. The photoconversion element 10 comprises further at least the following layers:
- a first transparent conductive electrode 11,
- a photoactive layer comprising at least one organic photoconversion layer 15, and
- a second transparent conductive electrode 19.

The layers of the photoconversion element 10 may be separated between each other by an intermediate layer. An example of an intermediate layer is a hole extraction layer 13 and an electron extraction layer 17.

The function of said at least one organic photoconversion layer 15 of the photoconversion element 10 is to separate the excitons that are formed by absorbed light into charges in said organic photoconversion layers. It should be noted that photoconversion elements are also known as light conversion elements, or light harvesting elements. The organic photoconversion layer considered in the invention have preferably strong absorption features outside the visible light spectrum, e.g. in the ultraviolet and particularly in the near-infrared part of the spectrum, said near infra-red part being defined as light between 670nm to 1400 nm

Said organic photoconversion layer(s) 15 may comprise, for instance, dyes chosen from the group comprising:
1. π-conjugated polyene systems and related compounds
   a. polyacatylene, cyclic polyene, cyclic polyene-yne, acene, rylene
   b. fullerene, graphene, CNT;
2. porphine and corrole dyes and related compounds;
3. phthalocyanine and naphthalocyanine dyes and related compounds (such as monomeric, dimeric, trimeric up to polymeric structures, such as mono-nuclear, di-nuclear up to poly-nuclear structures, such as dendritic and columnar structures) with metals such as, but not limited to Ni, Pt, Pd;
4. metal complex dyes, transition metal-ligand complexes (with metals such as, but not limited to Os, Ru, Cr, Cu, Ni, Co) and related compounds (such as monomeric, dimeric, trimeric up to polymeric structures, such as mono-nuclear, di-nuclear up to poly-nuclear structures, such as dendritic and columnar structures)
   a. dithiolene metal complexes with metals such as, but not limited to Ni, Pt, Pd
   b. benzosemiquinonato complexes with metals such as, but not limited to Zn, Ni
   c. formazyl metal complexes
   d. metal azo complexes
   e. polypiridyl dyes with metals such as, but not limited to Ru;
5. polymethine dyes and related compounds (such as monomeric, dimeric, trimeric up to polymeric structures, such as mono-nuclear, di-nuclear up to poly-nuclear structures, such as dendritic and columnar structures)
   a. cyanine dyes
   b. squaraine and croconate dyes
   c. merocyanine and oxonol dyes
   d. radical polymethine dyes
   e. cross-conjugated cyanine dyes, such as but not limited to borondipyrromethaenes, pyrrolopyrrole cyanine, diketopyrrolopyrrole;
6. diphenylmethane, triphenylmethane and related compounds (such as monomeric, dimeric, trimeric up to polymeric structures, such as mono-nuclear, di-nuclear up to poly-nuclear structures, such as dendritic and columnar structures)
7. quinone dyes and related compounds (such as monomeric, dimeric, trimeric up to polymeric structures, such as mono-nuclear, di-nuclear up to poly-nuclear structures, such as dendritic and columnar structures);
8. azo dyes and related compounds (such as monomeric, dimeric, trimeric up to polymeric structures, such as mono-nuclear, di-nuclear up to poly-nuclear structures, such as dendritic and columnar structures);
9. chromophoric systems and related compounds
   a. charge transfer type ππ* chromophores such as, but not limited to azamonomethine, indolizino-alquinoline, carbodinitrile
   b. charge resonance and molecular exciton type ππ* chromophores such as, but not limited to bichromophoric dyes, dye aggregates, TCNQ, dications, dianions
   c. non ππ* chromophore, σπ* and πσ* NIR chromophores such as, but not limited to nitroso compounds, cyclic conjugated disulfides, tetrachalcogenonaphthalenes;
10. radical dyes and related compounds (such as monomeric, dimeric, trimeric up to polymeric structures, such as mono-nuclear, di-nuclear up to poly-nuclear structures, such as dendritic and columnar structures);
11. π-conjugated D-A molecules, oligomers and polymers with a small optical gap and related compounds
   a. polythiophenes
   b. poly(3,4-ethylenedioxythiophene) PEDOT
   c. polyisothianaphthalenes
   d. copolymers based on isothianaphthalene
   e. copolymers of benzothiadiazole, pyrrole and thiophene
   f. copolymers based on thiophene, benzothiadiazole or benzo-bis (thiadiazole)
   g. copolymers based on thienopyranozine
   h. copolymere based on polyfluorene;
12. Non-fullerene acceptors (such as monomeric, dimeric, trimeric up to polymeric structures, such as mono-nuclear, di-nuclear up to poly-nuclear structures, such as dendritic and columnar structures) and related compounds
   a. rylene diimide based derivatives
   b. thiophenyl-S,S-dioxide based derivatives
   c. cyano poly(phenylenevinylene) based derivatives
   d. metallophthalocyanine derivatives
   e. pigments and dyes chosen among the above mentioned dyes 1. to 11
   f. 2-vinyl-4,5-dicyanoimidazole based derivatives
   g. diketopyrrolopyrrole based derivatives
   h. copolymers of fluorene and bis-(thienyl) benzothiadizole
   i. organoboron polymers
   j. cyanated pentacene derivatives
   k. 9,9'-bifluorenylidene derivatives

In an embodiment said organic photoconversion layer may comprise an inorganic sensitizer. A sensitizer is defined as a photoactive material that is added into the organic photoconversion layer, typically in small quantities (i.e. smaller quantities than the default photoactive material), in order to broaden the absorption spectrum to have a better overlap with the solar spectrum. Said sensitizers typically have much higher absorption coefficients than the default photoactive material, but in limited region of wavelengths. Said sensitizer may be nanocrystal quantum dots or may be perovskites nanocrystals that are embedded in said organic layer, quantum dots being described further in par. [0051].

In an embodiment said photoelectric conversion device 1 may comprise an inorganic photoconversion layer comprising at least perovskite, preferably a semiconducting perovskite, such as BaSnO, but not limited to BaSnO. Said semiconducting perovskite may be a synthetic perovskite. In a variant said perovskite material may be a hybrid inorganic-organic perovskite, preferably a trihalide perovskite (CH3NH3PbI3). Said perovskite may also be CH3NH3PBI(3-x)Clx or CH3NH3SnI3.

It should be noted here that said hybrid inorganic-organic perovskite being imbedded in said inorganic photoconversion layer is a hybrid inorganic-organic material, and comprises at least an organic part, for example CH3NH3, and an inorganic part, for example PBI3 or SnI3.

In an embodiment said organic photoconversion layer 15 may comprise one of said perovskite types and at least one of the dyes mentioned in [0041].

In an embodiment said photoconversion device 1 may comprise a perovskite layer, defined as a layer comprising at least one of the perovskite types described above.

In another embodiment, said photoconversion device 1 may comprise at least one quantum dot layer, said quantum dot layer being a layer comprising quantum dots as further described in par. [0050].

It should be noted that said perovskite layer or said quantum dot layer may be arranged to each side of said organic photoconversion layer 15. In a variant said photoconversion device 1 may comprise said organic photoconversion layer 15 and at least a quantum dot layer and a perovskite layer, said perovskite layer or said quantum dot layer may each be arranged to any side of said organic photoconversion layer 15. Any combination of stacking can be considered. In still another variant said photoconversion device 1 may comprise a photoconversion stack comprising a plurality of organic photoconveriosn layers and/or a plurality of said quantum dot layers and/or a plurality of said perovskite layers, each layer of said photoconversion stack may be arranged in any position in said stack.

In an embodiment, said organic photoconversion layer 15 may comprise different types of said quantum dots and at least one of the dyes mentioned in par. [0041]. In another embodiment said organic photoconversion layer 15 may comprise different types of perovskites.

In the context of the present invention a quantum dot layer is defined as a layer comprising quantum dots. Quantum dots are semiconductor particles that have been reduced below the size of the Exciton Bohr-radius, and due to quantum-mechanic considerations and the electron energies that can exist within them become finite, much alike energies in an atom. Quantum dots may be referred to as "articifial atoms". Their energy levels are tunable by changing their size, which in turn defines the bandgap. Quantum dots may produce more than one exciton from one high energy photon via the process of carrier multiplication or multiple exciton generation (MEG). This is very favorable compared with photoconversion layers which can manage one exciton per high-energy photon, with high energy carriers losing their energy as heat. Quantum dots may be realized in a cheap manner as they can be made using simple chemical reactions. Wet chemistry and improved cheap molecular beam epitaxy processes are an example of the way how to fabricate quantum dot layers. Quantum dots may be grown over a range of sizes, allowing them to express a wide variety of bandgaps without changing the underlying material or construction techniques. In typical wet chemistry preparations, said tuning is realized by varying the synthesis duration or temperature. The ability to tune the bandgap makes quantum dots desirable for solar cells. The combination of quantum dots with dyes as listed above may further increase the design possibilities of the photoconversion device 1 of the invention.

Quantum dots may be based on perovskites, for example perovskite nanocrystals. Quantum dots may also be PbS quantum dots, defined as quantum dots made of PbS molecules.

In an embodiment the quantum dot layer may comprise a plurality of layers of different types of quantum dots.

Fig.2b shows another exemplary arrangement of layers of a photoconversion element 10 comprising:
- a first transparent conductive electrode 11,
- a hole extraction layer 13,
- a photoactive layer comprising at least one organic photoconversion layer 15,
- an electron extraction layer 17,
- a transparent conductive polymer 21 , and
- a metal grid array 23 partially embedded in an electrically isolating polymer.

The layers of the photoconversion element 10 shown in Fig.2b may be separated between each other by an intermediate layer. The transparent conductive polymer comprises a second grating structure.

The design and realisation of the photoconversion element 10 itself, comprising at least one organic photoconversion layer 15, is well known in the literature, and need not be described further in more detail. Some publications on this subject are cited:
- J.Meis et al., "Near-infrared absorbing semitransparent organic solar cells", Applied physics letter 99, 193307-1, 2011
- R.Koeppe et al. ,"Organic solar cells with semitransparent metal back contacts for power window applications", ChemSusChem, 2, pp.309-313, 2009
- R.R.Lunt et al., « Transparent, near-infrared organic photovoltaic solar cells for window and energy-scavenging applications », Applied Physics Letters 98, 113305, 2011
- Patents: PCT/US2007/024651 ; US 2010/0186623 ; US 2012/0186623

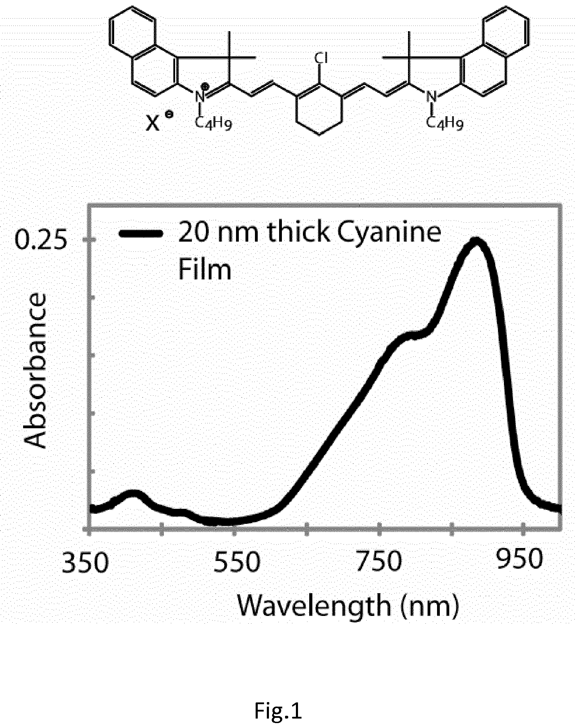

Photoconversion elements comprising organic photoconversion layers using said dyes are very transparent in the visible range of the spectrum but they are not completely color free due to an unbalanced transmittance in the visible range. The graph of Fig.1 shows an example of a partial absorption of red light in the case of cyanine dyes.

To improve the near-infra-red light conversion efficiency and to carry out a color correction of the appearance of the photoelectric conversion device due to the partial absorption of a part of the visible spectrum by the photoconversion element, the photoelectric conversion device further comprises a first grating structure and a second grating structure arranged adjacent to the organic photoconversion element.

In the generic embodiment illustrated in Fig. 9, the first grating structure 20 is arranged onto one of the surfaces of a waveguiding film 40, this waveguiding film 40 being positioned on one side of the photoconversion element 10. In the generic embodiment of Fig. 9 the photoelectric conversion device 1 is oriented so that the first grating structure is facing the light source.

The first grating structure 20 is designed to transmit a portion of the visible part 80 of the spectrum of the incident light on said first grating structure 20 and to direct the near-infra-red part 60 of the incoming light incident on said first grating structure 20 into said organic photoconversion layer 15. The angle of the diffracted near-infra-red light 60 by said first grating structure, i.e. the angle to the normal to said first grating structure 20 after diffraction by said first grating structure, is chosen to make the path length of the incoupled near-infra-red as long as possible in order to improve the photoconversion efficiency. The diffraction angle of the incoupled near-infra-red light 61 will preferably be chosen greater than 10°, preferably greater than 30 °, and even more preferably greater than 60°.

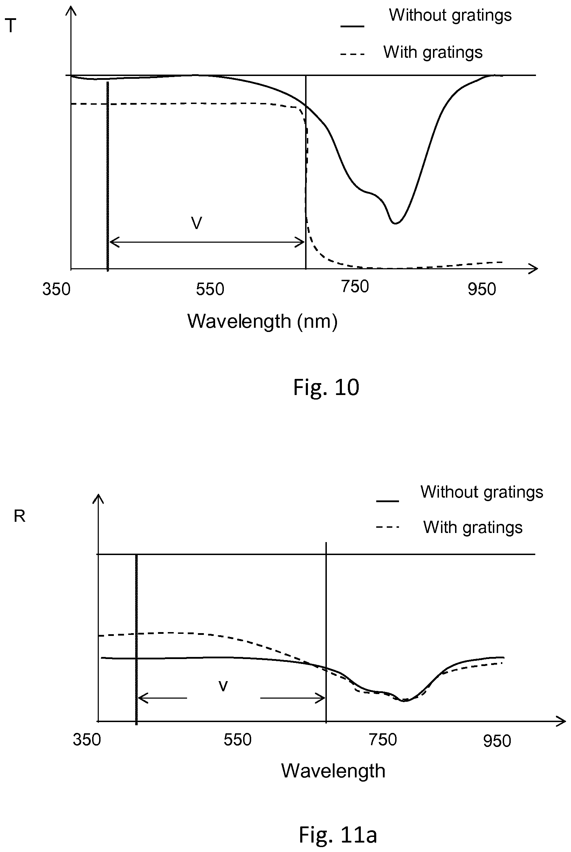

Besides coupling near-infra-red light into said photoconversion element, said first grating structure 20 is also designed as a color correction grating and reflects, to the side of the light source, as shown in Fig. 9, a portion of the complementary part of the visible light spectrum that is absorbed by the photoconversion element. For example, if the organic photoconversion layer comprises dyes that absorb red light, such as illustrated in Fig.1 for the case of cyanine dyes, said first grating structure 20 will be designed and arranged to reflect a portion 72 of the "green and blue light" 70 incident on said first grating structure 20. In consequence, an observer Oi looking at the photoelectric conversion device 1 from the side opposite to the light source LS see the device as grey, and from the side of the light source an observer Oo will see said photoelectric conversion device 1 as blue-green. This is illustrated in Fig. 10 and Fig. 11a, which show, for the embodiment of Fig. 9, the transmittance and reflection graphs of the photoelectric conversion device 1.

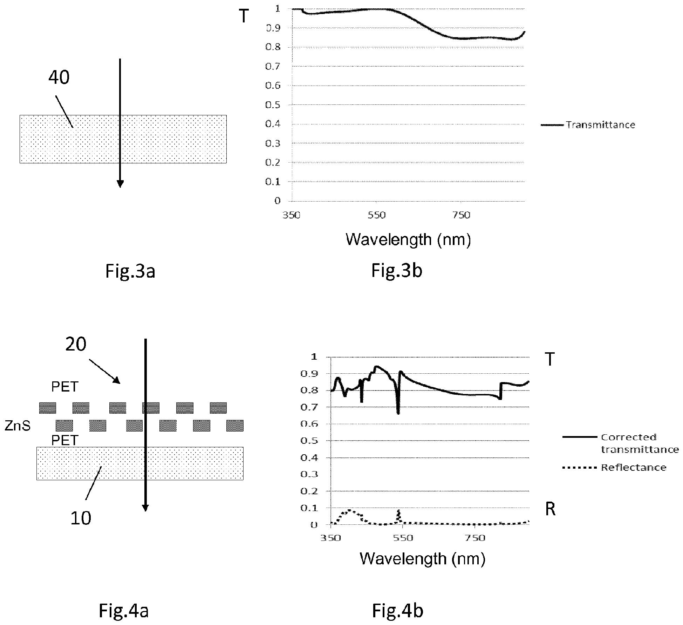

There are different ways to realize the first grating structure 20. Said first grating structure can be made for instance by embossing a Polyethylene carbonate (PEC) plastic waveguiding film, on which a ZnS diffraction enhancement layer is deposited. The transmission and reflection properties of an exemplary first grating structure 20 are shown in Fig. 4b. One can refer to the patent application PCT/EP2013/065631 filed by one of the applicants to obtain details regarding the design, the method of realization and the obtained transmission and light coupling characteristics of first grating structures 20. The grating structures taught in PCT/EP2013/065631 can be adapted directly to near-infra-red wavelengths. Examples of grating structures that can be adapted as first grating structures are disclosed in the patents EP1767964 and EP1990661.Said first grating structures 20 may be realized by any grating fabrication method adapted to plastic films. Materials for the waveguiding film 40 may be chosen from the group comprising glass, Polyethylene terephthalate (PET), Polycarbonate (PC), Polyethylene naphthalate (PEN), Polyethylene carbonate (PEC), Polymethyl methacrylate (PMMA), Polyesters, Polyethylene (PE), Polypropylene (PP), Polyethylene furanoate (PEF), polymers based on Poly (bis - cyclopentadiene) condensates, colorless polyimide (CP), cellulose, Polyether ether ketone (PEEK) polymers and combinations thereof. Fig.3b shows a transmission spectrum of a PEC polymer.

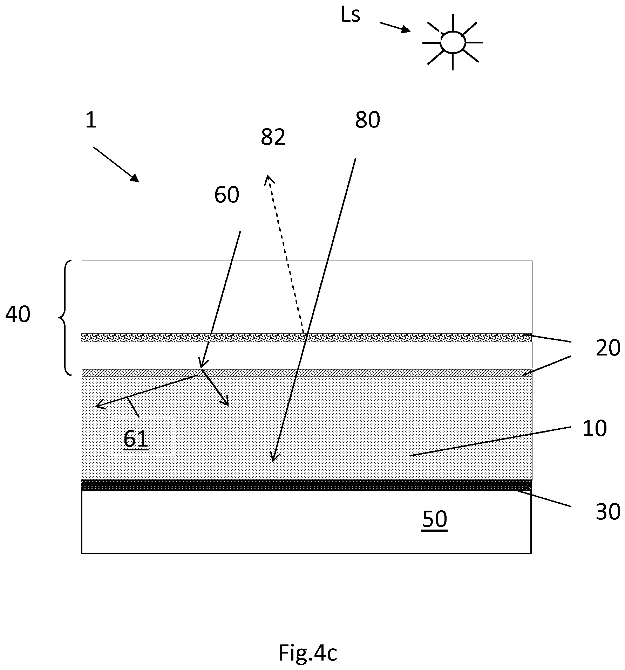

The first grating structure 20 may comprise at least two superposed grating structures as taught in PCT/EP2013/065631. In a variant, one of the at least two grating structures is a color correction grating, while the second of the at least two grating structures diffracts near-infra-red light towards and into said organic photoconversion layer, as illustrated in Fig.4c. Said two grating structures may be separated by a transparent layer. The transparent layer may be a dielectric layer.

The photoelectric conversion element 1 comprises further a substrate layer 50 comprising a second grating structure 30 arranged on one of the surfaces of said substrate layer 50. The substrate layer 50 is a layer on which the photoconversion elements 10 may be arranged. Said photoconversion elements 10 may be deposited on said substrate layer 50 or they may be connected to the substrate layer by any intermediate layer, such as a glue layer or any transparent layer. Said substrate layer 50 may have waveguiding properties. The material of the substrate layer may be chosen from similar materials as the materials mentioned for the waveguiding film 40.

The second grating structure 30 is designed and arranged to transmit visible light and also to reflect at least a part 62 of the near-infra-red portion 61 that is coupled into the photoconversion element by said first grating structure 20, thereby trapping said near-infra-red portion into said photoconversion element 10.

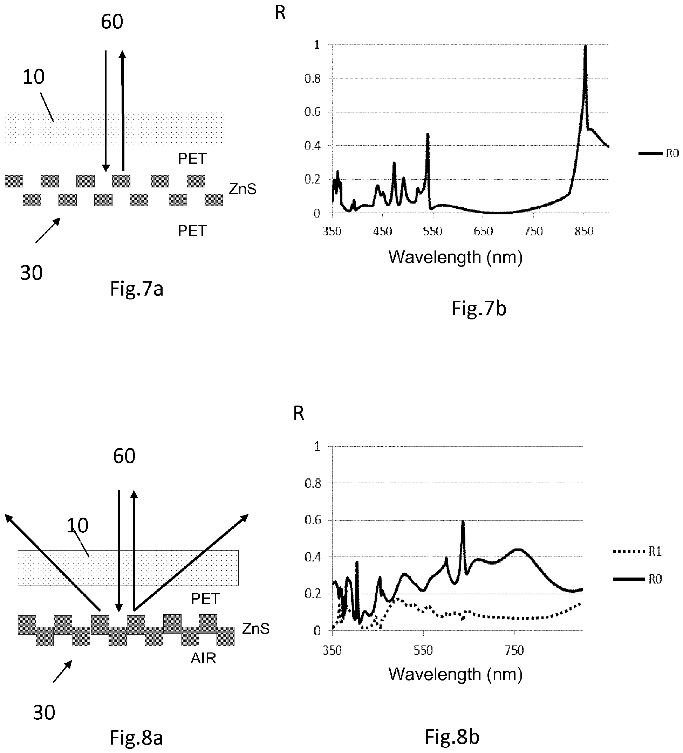

Fig. 7a and Fig. 8a show two possible configurations of said second grating structure 40 arranged to reflect at least a part of the near-infra-red portion that is coupled into the photoconversion element by said first grating structure. Said second grating structure 30 may be realized by a grating fabrication method similar to the fabrication methods used for said first grating structures 20.

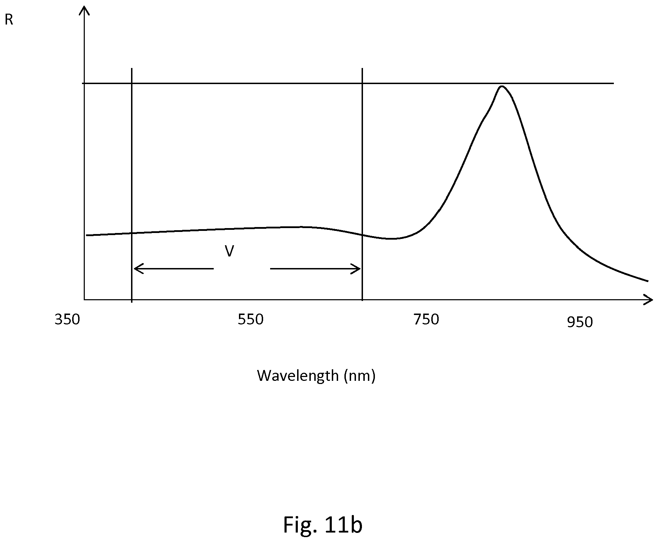

Fig. 11b shows the near-infra-red reflection curve of a second grating structure reflecting at least a part of the near-infra-red portion incident on said second grating structure 30.

The photoelectric conversion device 1 according to the generic embodiment illustrated in Fig.9 may be arranged as an energy harvesting device located on windows illuminated by the sun. The embodiment of Fig. 9 may also be deployed in the case of consumer electronics such as the display of a mobile phone, including transparent information displays. In the case of an electronic device the electronic display to which the photoelectric conversion device is attached is the artificial light source. This attachment may be done by gluing, by low or high pressure techniques or by any technique assuring that the photoelectric conversion device adheres to the window or screen. The artificial light source may also be integrated into a screen or window to which the photoconversion device 1 is arranged. The photoelectric conversion device may be arranged to one side of such screens. If the photoelectric conversion device is arranged to the side of the observer on said screens, the observer will see the photoelectric conversion device 1 as color neutral. If the observer is positioned to the side of the screens opposite to the photoconversion device (arranged on the screens), the observer will see the photoconversion device having a blue-green appearance.

A wide variety of applications of the photoelectric conversion device 1 are possible. For example, light emitting displays may be integrated into screens such as windshields of cars or other vehicles. In the case of car windows for instance tinted glass is a desired feature, and on some car front windows a colored sign or bar may be arranged. The photoelectric conversion device may be integrated as a design feature for expensive cars: the color of the sign or the bar or the window could change so that the apparent tint may change in function of the angle of incidence of the light source.

Another field of application is where semi-transparent light harvesting window shades are needed, possibly vertical or horizontal shades. Users may for instance tune the transmission intensity and color by changing the angle of the lamellae of the shades or shutters. The market may demand different degrees of transparency, but also different colors to match interior designs. Also, in different factories windows are needed where a portion of the spectrum of the incident light has to be filtered such as waferfabs requiring a yellow over-all illumination. Architectural designs of buildings are also an application, requiring a control of the color of the photoelectric conversion elements. Another application is the design of films having the shape of particular objects, such as artificial light-harvesting trees appearing green.

It will be understood that other color correction arrangements can be realized with the embodiment of Fig. 9, in function of the particular requirements of the application. For instance it may be chosen not to compensate fully the color appearance of the photoelectric conversion device 1 due to light having a wavelength range that is partially absorbed by the organic photoconversion layer, so that the photoelectric conversion device has a well determined colored appearance to an observer, at least seen from one of the sides of said photoelectric conversion device 1.

Said waveguiding film 40 and substrate layer 50 may further comprise each at least an anti-reflection layer. On at least one of the surfaces of said waveguiding film and/or said substrate layer, a dielectric coating may be applied. The dielectric coating may be a multilayer interference filter coating. The surface of the waveguiding film 40 opposite to said first grating structure 20 may comprise microlens arrays, or microprism arrays or diffractive gratings, or a combination of them, allowing for instance to change the angle and/or the aperture of the incident light beam on said first grating structure 40 . The surface of the substrate layer 50 opposite to said second grating structure 30 may comprise microlens arrays, or microprism arrays or diffractive gratings, or a combination of them, to change the angle and/or the aperture of the incident light beam on said second grating structure.

Said waveguiding film 40 and/or said substrate layer 50 may be separated from the photoconversion element 10 by a spacer or by a transparent layer, for example a dielectric layer. Said layer may comprise several different transparent layers.

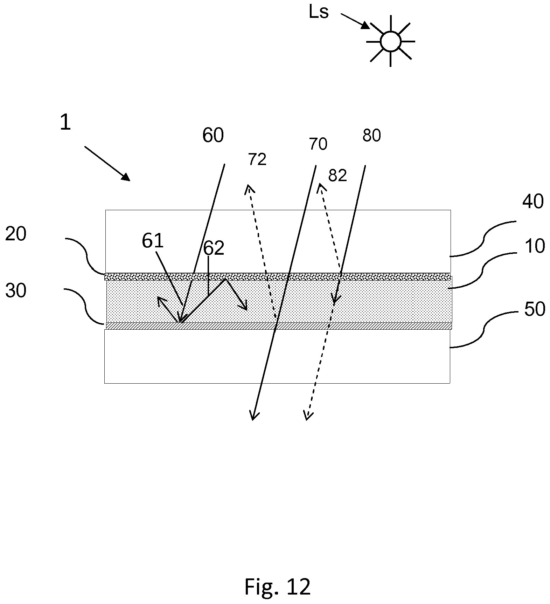

In the embodiment of the photoelectric conversion device 1, shown in Fig. 12, the structure of the photoelectric conversion device is quite similar to the one of Fig. 9, except that the first grating structure 20 is designed and arranged to reflect a portion 82 of the infalling light beam on the photoelectric conversion device, that would be absorbed by the photoconversion element if there were no first grating structure 40. In the embodiment of Fig. 12, most of said portion 82 of light will not be coupled inside the photoconversion element. The second grating structure of the photoconversion device shown in Fig.12 is designed to reflect a part 72 of the spectrum corresponding to the complementary part of said portion 82 of light. Said first grating structure and said second grating structure are further designed and arranged so that said reflected light beams 72 and 82, corresponding to red, green and blue portions of the light beam, produce a flat spectrum over the whole visible wavelength range.

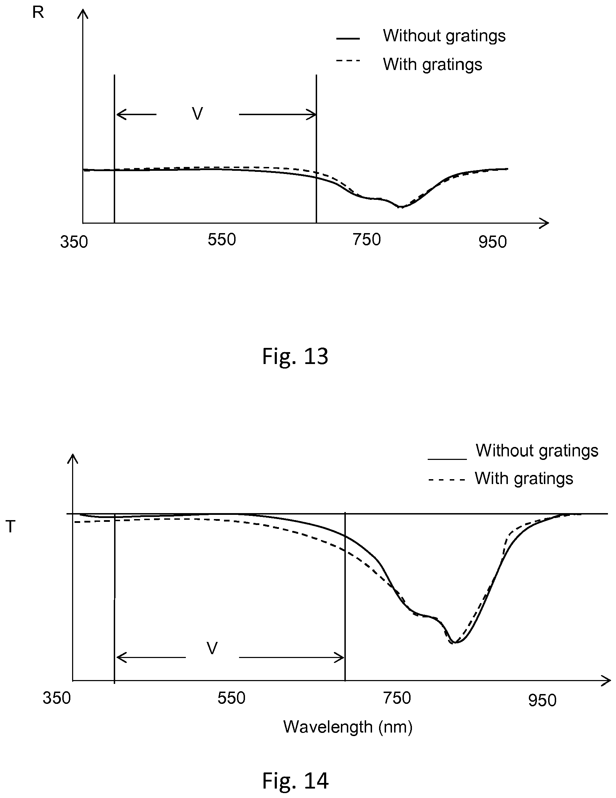

For example, the embodiment of Fig.12 may be used if the organic photoconversion layer comprises cyanine dyes presenting red light absorption. In that example the first grating structure will be designed and arranged to reflect most of the infalling red light on said first grating structure and second grating structure will be further designed as to reflect also a portion of the incident blue and green part of the spectrum so that an observer, positioned to the side of the light source of the photoelectric conversion device 1, will see said device 1 as color neutral. Figs. 13 and 14 show the visible and near-infrared transmission and reflection curves of the embodiment of Fig.12.

The typical situation in which the photoelectric conversion device 1 of Fig. 12 is used is quite similar to the ones mentioned for the embodiment of Fig. 9. The choice between the embodiments of Fig. 9 and Fig. 12 will be made in function of the materials of the photoconversion elements and the optical characteristics of the light source. The embodiment of Fig. 12 is intended to be used for typical situations such as a window illuminated by an indoor artificial light source in absence of sun light, i.e. a situation typical during the night. In such a situation an observer located to the light source side of the photoelectric conversion device 1 will see the photoconversion device as color neutral.

An observer positioned to the side of the photoelectric conversion device opposite to the artificial light source, i.e. typically an observer being outdoors looking to a window illuminated by an inside artificial light, will see the photoelectric conversion device 1 as having a greenish-blue tint. The embodiment of Fig. 12 may be arranged so that the photoelectric conversion device 1 has a specific predetermined color to an observer.

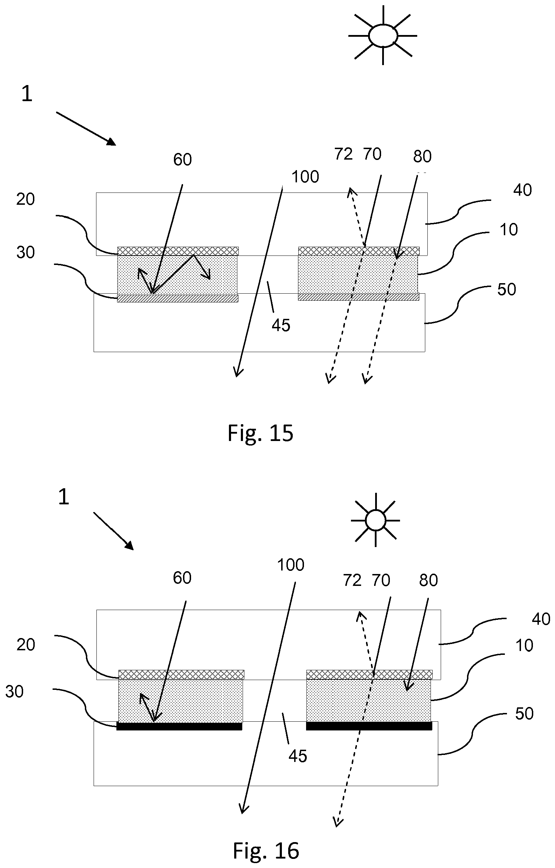

The embodiment represented in Fig. 15, is quite similar to the one of Fig. 9, and is intended to enhance the visible light transmission The difference with the embodiment of Fig. 9 is that in the embodiment of Fig. 15, the photoconversion element 10, arranged between a first grating structure 20 and a second grating structure 30, comprises a plurality of separate photoconversion elements 10 arranged in substantially the same plane. Said first grating structure 20 and said second grating structure 30 comprise each a plurality of independent grating structures. Each of said plurality of independent grating structures face each of said plurality of photoconversion elements 10. Each of said plurality of photoconversion elements and each of said plurality of independent grating structures are separated by a transparent layer 45 that is designed and arranged to pass visible light 100 straight through the photoelectric conversion device 1.

The embodiment represented in Fig. 16 is quite similar to the embodiment represented in Fig. 15, with the difference that that second grating structure 30 is a reflecting grating structure adapted to improve further the near-infrared light conversion efficiency.

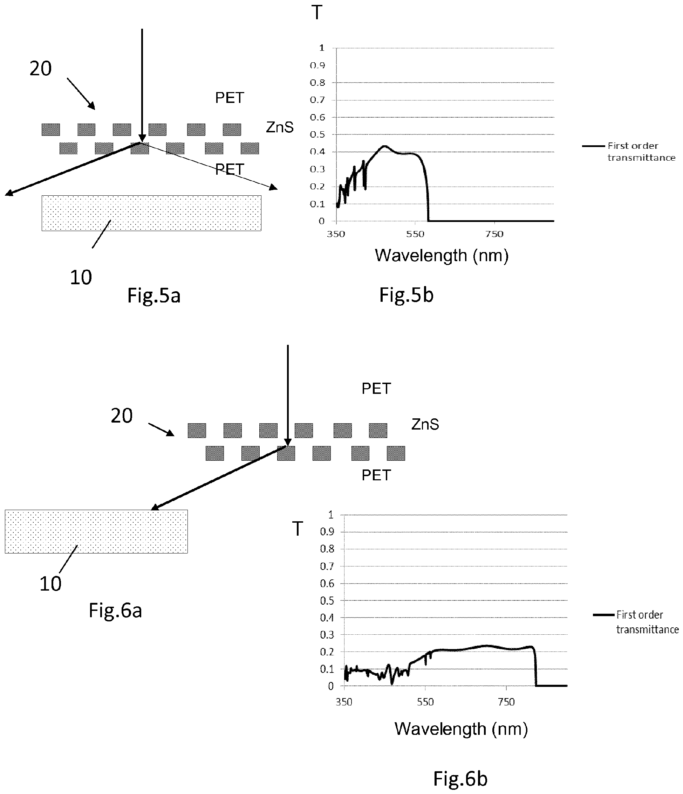

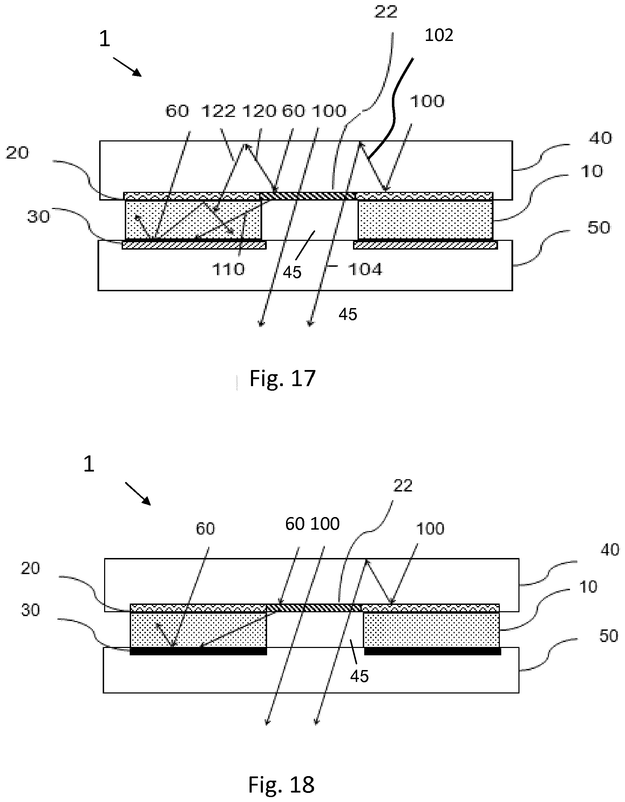

In another embodiment, shown in Fig. 17, further grating structures 22 are arranged between said first grating structures 20 comprising a plurality of grating structures. Said further grating structures 22 transmit visible light and diffract near-infra-red light towards plurality of photoelectric conversion elements 10. An example of an arrangement of a further grating structure 22 is shown in Fig. 6a. The first grating structure 20 of the embodiment shown in Fig. 17 is designed and arranged to reflect visible light 100. The reflected light 102 is coupled and guided, after said reflection by said first grating structure 20, into the waveguiding film 40 of the photoelectric conversion device 1. When said reflected and guided light 102 is incident on said further grating structure 22, it is transmitted by said further grating structure. The transmitted light beam 104 traverses the photoelectric conversion device 1 between said plurality of photoconversion elements 10. Said further gratings 22 are further designed and arranged to couple near-infra-red light 110 incident on said further gratings 22 towards and into adjacent photoconversion elements 10.

In another variant, at least a portion 120 of the near-infra-red light incident on said further gratings 22 could additionally be reflected by said further gratings 22, this portion 120 guided by the waveguide film 40 being subsequently coupled into the photoconversion elements by said first grating structures 20 as illustrated in Fig. 17. Said further gratings 22 may comprise at least two grating structures.

The further grating structure 22 may be arranged on any side of the waveguiding film 20, or at both sides. Further gratings structures 22 may at the same time transmit near-infra-red light, diffract near-infra-red light and reflect near-infra-red light.

The embodiment shown in Fig. 18 is quite similar to the one illustrated in Fig. 17 and differs in that said second grating structures 30 are reflecting grating structures.

In another embodiment similar to the one of Fig. 17 and illustrated in Fig.18 the second grating structure 30 is replaced by a reflector. The reflector may be a metallic mirror or may be a dielectric mirror. Said reflector may also be a metallic mirror comprising a dielectric coating.

The possible arrangements of the photoelectric conversion elements are not limited to the previously described embodiments. Additional features may be added to the described structural elements of the embodiments. For example, additional optical elements may be arranged to or into the photoelectric conversion device. As an example, microlens arrays, or coatings, or microprisms may be adapted on any of the surfaces of the waveguiding film and/or substrate layer. Additional layers may be disposed on the surfaces of the waveguiding film and/or the substrate layer. Said additional layers may be protection layers. Additional optical scattering microstructures may be imbedded in the waveguiding film and/or substrate layer and/or any layers of the photoelectric conversion device 1.

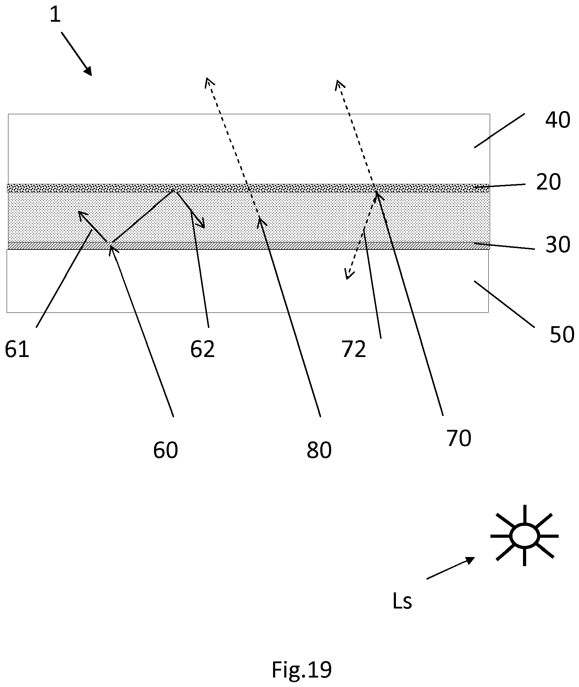

The invention is not limited to embodiments wherein the light source is to the side of the first grating structure 20 of the photoelectric conversion device 1. Similar embodiments may be devised wherein the light source is to the side of the second grating structure 30. In such a variant the first grating structure 20 may be designed as a reflection grating and arranged so as to reflect a portion of the transmitted visible light by the second grating structure 30, as illustrated in Fig 19.

In particular situations, according to the invention, the photoelectric conversion device 1 may be arranged to cope with the presence of at least two light sources, at least one light source being positioned to each side of the photoelectric conversion device 1.

According to another aspect of the invention, photoelectric conversion elements 10 may comprise at least two different photoelectric conversion elements, of which at least two photoelectric conversion elements are designed and arranged according to a different embodiment of the invention, and wherein said different photoelectric conversion elements 10 are connected so as to form a single photoelectric conversion element. Said at least two photoconversion elements 10 must not be arranged in a single plane and may be arranged and connected in different planes.

Also, the photoelectric conversion device 1 may be arranged for particular light sources, such as, but not limited to, high efficiency lighting sources such as solid state lighting sources.

The invention relates also to a method to generate electrical current, which will be directly understood by the skilled person from the description of the photoelectric conversion device 1 describes above.

## Claims

1. A photoelectric conversion device (1) comprising:
- at least one photoconversion element (10) comprising at least one organic or inorganic photoconversion layer, said inorganic layer comprising at least quantum dots or a semiconducting perovskite;
- at least a first grating structure (20) arranged on a first side of the photoconversion element;
- at least a second grating structure (30) arranged on a second side of the photoconversion element;
wherein said at least first grating structure (20) is arranged so as to direct a near-infra-red light portion of light incident on said first grating structure (20) into said photoconversion element (10), the said at least second grating structure (30) being arranged to reflect at least a part of said near-infra-red light portion back into said photoconversion element (1) and to pass visible light out of the photoelectric conversion device.

2. The photoelectric conversion device (1) according to claim 1, wherein the at least one photoconversion element comprises a plurality of separate photoconversion elements arranged in substantially the same plane, and wherein at least one of said first grating structures (20) and said second grating structures (30) comprise a plurality of independent grating structures.

3. The photoelectric conversion device (1) according to claim 2, wherein further grating structures (22) are provided in between each of said plurality of independent grating structures and arranged to direct near-infrared-light into the said photoconversion elements.

4. The photoelectric conversion device (1) according to any one of the preceding claims, wherein a transparent substrate (50) is arranged to at least one side of the photoconversion element (10).

5. The photoelectric conversion device (1) according to claim 4, wherein said second grating structure (20) is arranged on said transparent substrate (50).

6. The photoelectric conversion device (1) according to claim 4 or 5, wherein the at least one photoconversion element is a single continuous layer and wherein at least one of said first grating structure (20) and said second grating structure (30) is arranged as a single continuous layer and wherein at least one of said first grating structure (20) and said second grating structure (30) is arranged to reflect a portion of the visible light incident on said first grating structure (20) and/or second grating structure (30), said portion corresponding to the visible light with a wavelength range complementary to the absorbed wavelength range of the visible spectrum by said photoconversion element.

7. The photoelectric conversion device (1) according to claim 3 and any of claims 4 or 5, wherein a waveguiding film (40) is arranged to at least one side of the photoconversion element (10) and said first grating structure (20) is a reflective grating structure arranged to reflect visible light incident on said reflective grating structure, and wherein said waveguiding film (40) is arranged to guide said reflected visible light, and wherein said further gratings (22) are arranged to direct near infrared light onto the photoconversion elements (10), and wherein said further gratings (22) are arranged to transmit visible light.

8. The photoelectric conversion device (1) according to any of claims 1 to 7, wherein the at least one photoconversion element (10) comprising at least one inorganic layer comprising at least one of the following: quantum dots, semiconducting perovskite, preferably BaSnO perovskite, trihalide perovskite (CH3NH3PbI3), CH3NH3Pbl(3-x)Clx, CH3NH3SnI3.

9. Method of generating electrical current comprising the steps of:
- receiving incident light comprising at least near-infra-red and visible light at a photoelectric conversion device (1) according to one of claims 1-8;
- directing a near-infra-red light portion of said incident light into a photoconversion element (10) of said photoelectric conversion device (1), said photoconversion element (10) comprising at least one organic photoconversion layer, said photoconversion element (10) thereby producing an electrical current;
- redirecting at least a part of said near-infra-red light portion back into said photoconversion element (10);
- passing visible light out of the photoelectric conversion device (1).
wherein at least a portion of the visible part of the light incident on the photoelectric conversion device (1) is reflected and wherein another portion of said visible light is transmitted through the photoelectric conversion device, the reflected portion of the visible part of the light being reflected by means of at least one of a first grating structure (20) arranged on a first side of the photoconversion element and a second grating structure (30) arranged on a second side of the photoconversion element, said reflected portion corresponding to the visible light with a wavelength range complementary to the absorbed wavelength range of the visible spectrum by said photoconversion element.

## Patentansprüche

1. Lichtelektrische Wandlungsvorrichtung (1), umfassend:
- mindestens ein Lichtwandelelement (10), das mindestens eine organische oder anorganische Lichtwandelschicht umfasst, wobei die anorganische Schicht zumindest Quantenpunkte oder einen halbleitenden Perovskit umfasst;
- mindestens eine erste Gitterstruktur (20), die auf einer ersten Seite des Lichtwandelelements angeordnet ist;
- mindestens eine zweite Gitterstruktur (30), die auf einer zweiten Seite des Lichtwandelelements angeordnet ist;
wobei die mindestens eine erste Gitterstruktur (20) so angeordnet ist, dass sie einen Nah-Infrarotlichtteil von Licht, das auf die erste Gitterstruktur (20) auffällt, in das Lichtwandelelement (10) lenkt, und die zweite Gitterstruktur (30) so angeordnet ist, dass sie wenigstens einen Teil des Nah-Infrarotlichtteils zurück in das Lichtwandelelement (1) reflektiert und sichtbares Licht aus der lichtelektrischen Wandlungsvorrichtung austreten lässt.

2. Lichtelektrische Wandlungsvorrichtung (1) nach Anspruch 1, wobei das mindestens eine Lichtwandelelement eine Mehrzahl von getrennten Lichtwandelelementen umfasst, die im Wesentlichen in der gleichen Ebene angeordnet sind, und wobei mindestens eine der ersten Gitterstrukturen (20) und der zweiten Gitterstrukturen (30) eine Mehrzahl von unabhängigen Gitterstrukturen umfasst.

3. Lichtelektrische Wandlungsvorrichtung (1) nach Anspruch 2, wobei weitere Gitterstrukturen (22) zwischen jeder der Mehrzahl von unabhängigen Gitterstrukturen vorgesehen und so angeordnet sind, dass sie Nah-Infrarotlicht in die Lichtwandelelemente lenken.

4. Lichtelektrische Wandlungsvorrichtung (1) nach einem der vorhergehenden Ansprüche, wobei ein transparentes Substrat (50) zu mindestens einer Seite des Lichtwandelelements (10) angeordnet ist.

5. Lichtelektrische Wandlungsvorrichtung (1) nach Anspruch 4, wobei die zweite Gitterstruktur (20) auf dem transparenten Substrat (50) angeordnet ist.

6. Lichtelektrische Wandlungsvorrichtung (1) nach Anspruch 4 oder 5, wobei das mindestens eine Lichtwandelelement eine einzige durchgehende Schicht ist, und wobei mindestens eine von der ersten Gitterstruktur (20) und der zweiten Gitterstruktur (30) als eine einzige durchgehende Schicht angeordnet ist, und wobei mindestens eine von der ersten Gitterstruktur (20) und der zweiten Gitterstruktur (30) so angeordnet ist, dass sie einen Teil des sichtbaren Lichts reflektiert, das auf die erste Gitterstruktur (20) und/oder die zweite Gitterstruktur (30) auffällt, wobei der Teil dem sichtbaren Licht mit einem Wellenlängenbereich komplementär zum absorbierten Wellenlängenbereich des sichtbaren Spektrums durch das Lichtwandelelement entspricht.

7. Lichtelektrische Wandlungsvorrichtung (1) nach Anspruch 3 und einem der Ansprüche 4 oder 5, wobei ein Wellenleitfilm (40) zu mindestens einer Seite des Lichtwandelelements (10) angeordnet ist, und die erste Gitterstruktur (20) eine reflektierende Gitterstruktur ist, die so angeordnet ist, dass sie sichtbares Licht reflektiert, das auf die reflektierende Gitterstruktur auffällt, und wobei der Wellenleitfilm (40) zum Leiten des reflektierten sichtbaren Lichts angeordnet ist, und wobei die weiteren Gitter (22) zum Lenken von Nah-Infrarotlicht auf die Leichtwandelelemente (10) angeordnet sind, und wobei die weiteren Gitter (22) zum Durchlassen von sichtbarem Licht angeordnet sind.

8. Lichtelektrische Wandlungsvorrichtung (1) nach einem der Ansprüche 1 bis 7, wobei das mindestens eine Lichtwandelelement (10) mindestens eine organische Schicht umfasst, die mindestens eines von Folgendem umfasst: Quantenpunkten, halbleitendem Perovskit, vorzugsweise BaSnO-Perovskit, Trihalogenid-Perovskit (CH3NH3PbI3), CH3NH3Pbl(3-x)Clx, CH3NH3SnI3.

9. Verfahren zur Erzeugung elektrischen Stroms, umfassend die folgenden Schritte:
- Empfangen von einfallenden Licht, das zumindest Nah-Infrarot- und sichtbares Licht umfasst, an einer lichtelektrischen Wandlungsvorrichtung (1) nach einem der Ansprüche 1 bis 8;
- Lenken eines Nah-Infrarotlichtteils des einfallenden Lichts in ein Lichtwandelelement (10) der lichtelektrischen Wandlungsvorrichtung (1), wobei das Lichtwandelelement (10) mindestens eine organische Lichtwandelschicht umfasst, und das Lichtwandelelement (10) dadurch einen elektrischen Strom erzeugt;
- Ablenken wenigstens eines Teils des Nah-Infrarotlichtteils zurück in das Lichtwandelelement (10);
- Austretenlassen von sichtbarem Licht aus der lichtelektrischen Wandlungsvorrichtung (1),
wobei wenigstens ein Teil des sichtbaren Teils des Lichts, das auf die lichtelektrische Wandlungsvorrichtung (1) auffällt, reflektiert wird, ein anderer Teil des sichtbaren Lichts durch die lichtelektrische Wandlungsvorrichtung durchgelassen wird, und der reflektierte Teil des sichtbaren Teil des Lichts durch mindestens eine von einer ersten Gitterstruktur (20), die auf einer ersten Seite des Lichtwandelelements angeordnet ist, und einer zweiten Gitterstruktur (30), die auf einer zweiten Seite des Lichtwandelelements angeordnet ist, reflektiert wird, wobei der reflektierte Teil dem sichtbaren Licht mit einem Wellenlängenbereich komplementär zum absorbierten Wellenlängenbereich des sichtbaren Spektrums durch das Lichtwandelelement entspricht.

## Revendications

1. Dispositif de conversion photoélectrique (1) comprenant :
- au moins un élément de photoconversion (10) comprenant au moins une couche de photoconversion organique ou inorganique, ladite couche inorganique comprenant au moins des points quantiques ou une pérovskite semi-conductrice ;
- au moins une première structure de réseau (20) agencée sur un premier côté de l'élément de photoconversion ;
- au moins une seconde structure de réseau (30) agencée sur un second côté de l'élément de photoconversion ;
dans lequel ladite au moins une première structure de réseau (20) est agencée de façon à diriger une partie de lumière proche infrarouge de la lumière incidente sur ladite première structure de réseau (20) dans ledit élément de photoconversion (10), ladite au moins une seconde structure de réseau (30) est agencée pour réfléchir au moins une partie de ladite partie de lumière proche infrarouge de nouveau dans ledit élément de photoconversion (1) et pour faire passer la lumière visible à l'extérieur du dispositif de conversion photoélectrique.

2. Dispositif de conversion photoélectrique (1) selon la revendication 1, dans lequel l'au moins un élément de photoconversion comprend une pluralité d'éléments de photoconversion séparés agencés sensiblement dans le même plan, et dans lequel au moins une desdites premières structures de réseau (20) et desdites secondes structures de réseau (30) comprend une pluralité de structures de réseau indépendantes.

3. Dispositif de conversion photoélectrique (1) selon la revendication 2, dans lequel d'autres structures de réseau (22) sont utilisées entre chacune de ladite pluralité de structures de réseau indépendantes et agencées pour diriger la lumière proche infrarouge dans lesdits éléments de photoconversion.

4. Dispositif de conversion photoélectrique (1) selon l'une quelconque des revendications précédentes, dans lequel un substrat transparent (50) est agencé sur au moins un côté de l'élément de photoconversion (10).

5. Dispositif de conversion photoélectrique (1) selon la revendication 4, dans lequel ladite seconde structure de réseau (20) est agencée sur ledit substrat transparent (50).

6. Dispositif de conversion photoélectrique (1) selon la revendication 4 ou 5, dans lequel l'au moins un élément de photoconversion est une couche continue unique et dans lequel au moins une de ladite première structure de réseau (20) et de ladite seconde structure de réseau (30) est agencée sous forme de couche continue unique et dans lequel au moins une de ladite première structure de réseau (20) et de ladite seconde structure de réseau (30) est agencée pour réfléchir une partie de la lumière visible incidente sur ladite première structure de réseau (20) et/ou ladite seconde structure de réseau (30), ladite partie correspondant à la lumière visible avec une plage de longueur d'onde complémentaire de la plage de longueur d'onde absorbée du spectre visible par ledit élément de photoconversion.

7. Dispositif de conversion photoélectrique (1) selon la revendication 3 et selon l'une quelconque des revendications 4 à 5, dans lequel un film de confinement optique (40) est agencé sur au moins un côté de l'élément de photoconversion (10) et ladite première structure de réseau (20) est une structure de réseau réfléchissante agencée pour réfléchir la lumière visible incidente sur ladite structure de réseau réfléchissante, et dans lequel ledit film de confinement optique (40) est agencé pour guider ladite lumière visible réfléchie, et dans lequel lesdites autres structures de réseau (22) sont agencées pour diriger la lumière proche infrarouge sur les éléments de photoconversion (10), et dans lequel lesdites autres structures de réseau (22) sont agencées pour transmettre la lumière visible.

8. Dispositif de conversion photoélectrique (1) selon l'une quelconque des revendications 1 à 7, dans lequel l'au moins un élément de photoconversion (10) comprend au moins une couche inorganique comprenant au moins un des éléments suivants : des points quantiques, une pérovskite semi-conductrice, de préférence la pérovskite BaSnO, une pérovskite de trihalogénure (CH3NH3PbI3), CH3NH3Pbl(3-x)Clx, CH3NH3SnI3.

9. Procédé de production d'un courant électrique comprenant les étapes consistant à :
- recevoir une lumière incidente comprenant au moins le proche infrarouge et la lumière visible au niveau d'un dispositif de conversion photoélectrique (1) selon l'une quelconque des revendications 1 à 8 ;
- diriger une partie de la lumière proche infrarouge de ladite lumière incidente dans un élément de photoconversion (10) dudit dispositif de conversion photoélectrique (1), ledit élément de photoconversion (10) comprenant au moins une couche de photoconversion organique, ledit élément de photoconversion (10) produisant ainsi un courant électrique ;
- rediriger au moins une partie de ladite partie de lumière proche infrarouge de nouveau dans ledit élément de photoconversion (10) ;
- faire passer la lumière visible à l'extérieur du dispositif de conversion photoélectrique (1),
dans lequel au moins une partie de la partie visible de la lumière incidente sur le dispositif de conversion photoélectrique (1) est réfléchie et dans lequel une autre partie de ladite lumière visible est transmise par le dispositif de conversion photoélectrique, la partie réfléchie de la partie visible de la lumière étant réfléchie au moyen d'au moins une d'une première structure de réseau (20) agencée sur un premier côté de l'élément de photoconversion et d'une seconde structure de réseau (30) agencée sur un second côté de l'élément de photoconversion, ladite partie réfléchie correspondant à la lumière visible avec une plage de longueur d'onde complémentaire de la plage de longueur d'onde absorbée du spectre visible par ledit élément de photoconversion.
